# EUROPÄISCHE PATENTSCHRIFT

(11) **EP 2 462 789 B1**
(45) Veröffentlichungstag und Bekanntmachung des Hinweises auf die Patenterteilung: **27.03.2013**
(21) Anmeldenummer: 10735237.9
(22) Anmeldetag: 14.07.2010
(51) Int. Cl.: H05K 3/42, G01N 27/407

(54) **SENSORELEMENT MIT DURCHKONTAKTIERLOCH**
SENSOR ELEMENT COMPRISING INTERLAYER CONNECTION HOLE
ÉLÉMENT CAPTEUR AVEC TROU MÉTALLISÉ

(30) Priorität: 03.08.2009 DE 102009028194
(43) Veröffentlichungstag der Anmeldung: 13.06.2012
(73) Patentinhaber: Robert Bosch GmbH, 70442 Stuttgart (DE)
(72) Erfinder: DOTTERWEICH, Oliver, 96173 Oberhaid (DE); TAEUBER, Antje, 96114 Hirschaid (DE); SCHNEIDER, Jens, 71229 Leonberg (DE); LEUSCHNER, Thomas, 96120 Bischberg (DE); COUTO PETRI, Dulce Maria, 70469 Stuttgart (DE); RENGER, Christoph, 87439 Kempten (DE); SAUERHAMMER, Michael, 96050 Bamberg (DE); ROTTMANN, Andreas, 97475 Zeil A. Main (DE)
(86) Internationale Anmeldenummer: PCT/EP2010/060121
(87) Internationale Veröffentlichungsnummer: WO 2011/015432

(56) Entgegenhaltungen:
- EP-A1- 2 058 650
- EP-A2- 0 528 311
- DE-A1-102004 025 949
- US-A1- 2009 308 651

## Beschreibung

### Stand der Technik

Die Erfindung geht aus von bekannten Sensorelementen, welche auf elektrolytischen Eigenschaften bestimmter Festkörper beruhen, also der Fähigkeit dieser Festkörper, bestimmte Ionen zu leiten. Derartige Sensorelemente werden insbesondere in Kraftfahrzeugen eingesetzt, insbesondere als Lambdasonden. Auch auf andere Arten von Sensorelementen, welche Festelektrolyte der beschriebenen Art umfassen, ist die Erfindung jedoch anwendbar, zum Beispiel auf Sensoren zum Nachweis anderer gasförmiger Bestandteile von Abgasen und auf Partikelsensoren. Die Erfindung betrifft ein Sensorelement sowie ein Verfahren zur Herstellung eines Sensorelements, insbesondere eines erfindungsgemäßen Sensorelements.

Eine bekannte Problematik bei der Herstellung von Sensorelementen, welche mindestens eine Festelektrolytschicht aufweisen, besteht darin, dass elektrische Durchkontaktierungen durch die Festelektrolytschicht hergestellt werden müssen, welche nicht in leitendem Kontakt mit der Festelektrolytschicht stehen sollen. Die Durchkontaktierung wird daher in der Regel durch Isolationsschichten elektrisch gegen den Festelektrolyten isoliert.

Die in der DE 100 14 995 C1 dargestellte Durchkontaktierung weist leitende und isolierende Schichten auf, die in einem Durchkontaktierloch in einer Festelektrolytschicht eines keramischen Messfühlers angeordnet sind. Hierbei hat das Durchkontaktierloch die Gestalt eines geraden Kreiszylinders, dessen Achse senkrecht zur Oberfläche der Festelektrolytschicht angeordnet ist. Die Wand des Durchkontaktierlochs stößt entlang einer rechwinkligen Kante auf die Oberfläche der Festelektrolytschicht.

Nachteilig an der bekannten Durchkontaktierung ist es, dass es im Fertigungsprozess schwierig sicherzustellen ist, dass die Dicke der isolierenden Schicht im Durchkontaktierloch zwischen einer Mindestdicke und einer höchstzulässigen Dicke liegt. Insbesondere ist es schwierig sicherzustellen, dass im Bereich der Kanten des Durchkontaktierlochs die Mindestdicke nicht unterschritten wird. Hierdurch wäre die Isolationswirkung der isolierenden Schicht beeinträchtigt. Ferner ist es insbesondere schwierig sicherzustellen, dass im Bereich der Wand des Durchkontaktierungslochs, insbesondere im Bereich unterhalb der Kanten des Durchkontaktierlochs eine höchstzulässige Dicke der isolierenden Schicht nicht überschritten wird. Eine solche Überschreitung hat im Fertigungsprozess die Konsequenz, dass übermäßig viel Lösungsmittel aus der der Herstellung der isolierenden Schicht dienenden Substanz in die der Herstellung der Festelektrolytschicht dienenden Substanz gelangt, wodurch diese Substanz geschädigt wird und es in der fertig gestellten Festelektrolytschicht zu Rissen kommen kann.

### Vorteile der Erfindung

Erfindungsgemäße Sensorelemente mit den Merkmalen des Anspruchs 1 haben hingegen den Vorteil, dass sie sich einfach herstellen lassen, insbesondere dadurch, dass sich einfach sicherstellen lässt, dass die Isolation im Bereich des Durchkontaktierlochs eine definierte Schichtdicke aufweist.

Dadurch, dass die Wand des Durchkontaktierlochs eine Fase aufweist, verbessert sich die Zugänglichkeit der Wand des Durchkontaktierlochs für die Aufbringung von Substanzen zur Herstellung einer Isolationsschicht. Ferner wird durch die erfindungsgemäß vorgesehene Fase vermieden, dass die Wand des Durchkontaktierlochs und die Außenfläche der Festelektrolytschicht entlang einer Kante scharfkantig aufeinanderstoßen. Hierdurch kann im Fertigungsprozess einerseits vermieden werden, dass es im Bereich der Kante zu einer zu dünnen oder gar unterbrochenen Isolation kommt, andererseits kann das Entstehen einer zu dicken Isolationsschicht im Inneren der Durchkontaktierung ebenfalls vermieden werden.

Weitere, den Stand der Technik beschreibende Dokumente sind EP 2 058 650 A1, sowie DE 10 2004 025949 A1, JP 2009-147060 A, EP 0 528 311 A2.

Als Mindestdicke ist eine Dicke der Isolation im Bereich zwischen 5µm und 20µm, zum Beispiel eine Dicke von 10µm anzusehen. Als höchstzulässige Dicke ist eine Dicke der Isolation im Bereich zwischen 15µm und 35µm, zum Beispiel eine Dicke von 20µm anzusehen. Es ist, insbesondere im Zusammenspiel mit der Form des Durchkontaktierungslochs, besonders günstig, die Isolation mit einer Schichtdicke vorzusehen, die zumindest im Wesentlichen im gesamten Durchkontaktierloch zwischen der Mindestdicke und der höchstzulässigen Dicke liegt.

Im Allgemeinen versteht man unter einer Fase eine Fläche, die zwischen einer ersten und einer zweiten Fläche angeordnet ist und deren Neigung größer ist als die Neigung der ersten Fläche und kleiner als die Neigung der zweiten Fläche.

Im Rahmen dieser Anmeldung ist unter der Fase einer Wand eines Durchkontaktierlochs einer Festelektrolytschicht insbesondere ein Teil der Wand des Durchkontaktierlochs zu verstehen, der zwischen einer Großfläche der Festelektrolytschicht und einem weiteren Teil der Wand des Durchkontaktierlochs angeordnet ist, wobei die Neigung der Wand in dem weiteren Teil der Wand in radialer Richtung zumindest weitgehend konstant ist, und insbesondere zumindest weitgehend senkrecht zur Neigung der Großfläche der Festelektrolytschicht ist, wobei in dem Teil der Wand des Durchkontaktierlochs die Neigung der Wand in radialer Richtung zwischen der Neigung der Wand in radialer Richtung in dem weiteren Teil der Wand des Durchkontaktierlochs und der Neigung der Großfläche der Festelektrolytschicht liegt.

Ein derartiger Teil der Wand eines Durchkontaktierlochs einer Festelektrolytschicht ist insbesondere dann als Fase aufzufassen, wenn er ausgedehnter ist als ein derartiger Bereich, der üblicherweise und fertigungsbedingt zwangsläufig bei der Herstellung eines Durchkontaktierlochs in einer Festelektrolytschicht entsteht. Derartige Bereiche reichen beispielsweise bis in eine Tiefe von weniger als 1µm, insbesondere weniger als 3µm, insbesondere weniger als 9µm des Durchkontaktierlochs.

Unter der Neigung der Wand eines Durchkontaktierlochs in radialer Richtung ist im Rahmen dieser Anmeldung die Neigung der Wand eines Durchkontaktierlochs in der Richtung zu verstehen, die lokal senkrecht zur umlaufenden Kante des Durchkontaktierlochs orientiert ist. Bei Vorliegen einer zylindrischen Achssymmetrie des Durchkontaktierlochs ist dies die Richtung, die von der Achse des Durchkontaktierlochs zur Wand des Durchkontaktierlochs zeigt.

Unter Großflächen einer Festelektrolytschicht werden im Rahmen dieser Anmeldung deren Oberseite und deren Unterseite verstanden.

Wenn die Fase bis in eine Tiefe von nicht weniger als 25µm, insbesondere von nicht weniger als 75µm, in das Durchkontaktierloch reicht und/oder wenn die Fase bis in eine Tiefe von nicht weniger als 5% der Dicke der ersten Festelektrolytschicht, insbesondere von nicht weniger als 15% der Dicke der ersten Festelektrolytschicht, in das Durchkontaktierloch reicht, sind die genannten vorteilhaften Effekte der Fase besonders ausgeprägt, beispielsweise ist die Zugänglichkeit der Wand des Durchkontaktierlochs für die Aufbringung von Substanzen zur Herstellung einer Isolationsschicht besonders deutlich verbessert.

Weist die Fase zumindest einen geraden Bereich auf, der in radialer Richtung gerade ist, wobei sich der gerade Bereich der Fase insbesondere über die gesamte Fase erstreckt, ergibt sich der Vorteil, dass sich eine derartige Fase besonders einfach, mit herkömmlichen Werkzeugen fertigen lässt. Bildet überdies der gerade Bereich der Fase mit der Oberseite der ersten Festelektrolytschicht und/oder der Unterseite der ersten Festelektrolytschicht einen Winkel von nicht weniger als 15° und von nicht mehr als 75°, insbesondere von nicht weniger als 30° und von nicht mehr als 60°, so werden Scharfkantigkeiten im Bereich der Kante des Durchkontaktierlochs besonders wirkungsvoll vermieden.

Ebenfalls besonders wirkungsvoll werden Scharfkantigkeiten im Bereich der Kante des Durchkontaktierlochs vermieden, wenn die Fase zumindest einen gekrümmten Bereich aufweist, der in radialer Richtung abgerundet ist, insbesondere dann wenn der entsprechende Krümmungsradius 10µm bis 200µm, insbesondere 25µm bis 115µm, beträgt, insbesondere dann, wenn sich der gekrümmte Bereich der Fase über die gesamte Fase erstreckt und/oder insbesondere dann, wenn das Durchkontaktierloch im Bereich der gekrümmten Fase eine konkave Form aufweist.

Eine weitere Optimierung der Fase hinsichtlich ihrer vorteilhaften Wirkungen wird möglich, wenn die Fase zwei voneinander verschiedene Bereiche, eine erste Teilfase und eine zweite Teilfase aufweist

Ist ferner vorgesehen, dass in Aufsicht auf die Festelektrolytfolie die erste Teilfase innerhalb der zweiten Teilphase angeordnet ist.

Es ist alternativ oder zusätzlich vorgesehen, dass die zweite Teilphase zwischen einer Großfläche der Festelektrolytschicht und der ersten Teilfase angeordnet ist, wobei in der zweiten Teilfase eine Neigung der Wand in radialer Richtung zwischen einer Neigung der Wand in radialer Richtung in der ersten Teilfase und der Neigung der Großfläche der Festelektrolytschicht liegt. Die zweite Teilphase stellt dann gleichsam eine Fase der Fase der Wand des Durchkontaktierlochs dar. Es ergeben sich in diesem Fall sehr weitreichende Vorteile, die die einfache Herstellbarkeit des Sensorelements und die Zuverlässigkeit der Isolation im Bereich des Durchkontaktierlochs und damit letztlich die Lebensdauer des Sensorelements betreffen.

Wenn die zweite Teilfase bis in eine Tiefe von nicht weniger als 10µm, insbesondere von nicht weniger als 30µm, in das Durchkontaktierloch reicht und/oder bis in eine Tiefe von nicht weniger als 2,5% der Dicke der ersten Festelektrolytschicht, insbesondere von nicht weniger als 7,5% der Dicke der ersten Festelektrolytschicht, in das Durchkontaktierloch reicht, ist die Zugänglichkeit der Wand des Durchkontaktierlochs für die Aufbringung von Substanzen zur Herstellung einer Isolationsschicht besonders deutlich verbessert.

Wenn die zweite Teilfase bis in eine Tiefe von nicht mehr als 100µm, insbesondere von nicht mehr als 50µm, in das Durchkontaktierloch reicht und/oder bis in eine Tiefe von nicht mehr als 20% der Dicke der ersten Festelektrolytschicht, insbesondere von nicht mehr als 10% der Dicke der ersten Festelektrolytschicht, in das Durchkontaktierloch reicht, lässt sie sich besonders einfach fertigen.

Eine Ausführung, in der während der Herstellung des Sensorelements eine vollständige Benetzung der Wand mit isolierendem Material besonders sichergestellt ist, sieht vor, dass die erste Teilfase und die zweite Teilfase jeweils in radialer Richtung zumindest bereichsweise gerade sind und in radialer Richtung unter einem Teilfasenwinkel aufeinanderstoßen, insbesondere unter einem Teilfasenwinkel von nicht weniger als 10° und von nicht mehr als 55°, insbesondere unter einem Teilfasenwinkel von nicht weniger als 25° und von nicht mehr als 45°.

Eine weitere Ausführung, in der während der Herstellung des Sensorelements eine vollständige Benetzung der Wand mit isolierendem Material besonders sichergestellt ist, sieht vor, dass die zweite Teilfase mit der Oberseite der Festelektrolytschicht oder der Unterseite der Festelektrolytschicht einen Winkel von nicht weniger als 3° und von nicht mehr als 25°, insbesondere von nicht weniger als 6° und von nicht mehr als 16°, einschließt.

Erprobungen der Anmelderin haben ergeben, dass die Lebensdauer der Sensorelemente insbesondere dann besonders hoch ist, wenn die zweite Teilfase in radialer Richtung zumindest bereichsweise gerade ist und die erste Teilfase in radialer Richtung zumindest bereichsweise abgerundet ist, insbesondere mit einem Krümmungsradius von 10µm bis 200µm, insbesondere mit einem Krümmungsradius von 25µm bis 115µm, wobei insbesondere die zweite Teilfase und die erste Teilfase in radialer Richtung unter einem Teilfasenwinkel von weniger als 5°, insbesondere weniger als 1°, insbesondere plan, aufeinanderstoßen, insbesondere dann, wenn die zweite Teilfase mit der Oberseite der Festelektrolytschicht oder der Unterseite der Festelektrolytschicht einen Winkel von nicht weniger als 3° und von nicht mehr als 25°, insbesondere von nicht weniger als 6° und von nicht mehr als 16°, einschließt.

Zweckmäßigerweise umfasst ein Verfahren zur Herstellung eines erfindungsgemäßen Sensorelements die im unabhängigen Verfahrensanspruch genannten Schritte, insbesondere in der genannten Reihenfolge.

Besonders vorteilhaft kommt hierbei zum Einbringen des Durchkontaktierlochs in die Festelektrolytfolie zumindest ein Werkzeug, zum Beispiel ein mechanischer Bohrer oder ein Stanzwerkzeug oder aber auch ein Laserstrahl, zum Einsatz, dessen Form der Form der herzustellenden Bohrung entspricht, oder der einen Teilbereich aufweist, der zumindest der Form eines Teiles der herzustellenden Bohrung aufweist. So kann das Werkzeug beispielsweise in einem distalen Bereich eine zylindrische Form aufweisen der sich in proximaler Richtung an einen Bereich anschließt, der entsprechend der Fase des Durchkontaktierlochs geformt ist. Auch der Einsatz eines Werkzeuges, dessen Form der Form der Fase des Durchkontaktierlochs entspricht, oder das einen Teilbereich aufweist, der der Form der Fase oder der Form eines Teils der Fase entspricht, ist denkbar.

Handelt es sich bei dem Werkzeug um einen Laserstrahl, so ist die Form des Laserstrahls im Sinne der DIN EN ISO 11145 zu verstehen. Es ergibt sich bei der Verwendung eines Laserstrahls der Vorteil, dass auch Hinterschnitte erzeugt werden können. Es kann also beispielsweise mit nur einseitigem (Laser-)Bohren ein Durchkontaktierloch eingebracht werden, das an seiner Oberseite und an seiner Unterseite je eine Fase aufweist.

Besonders bevorzugt erfolgt das Einbringen einer Isolationspaste und/oder einer Isolationssuspension in das Durchkontaktierloch durch zweiseitiges Saugen, wobei jeweils auf einer Großfläche der Festelektrolytfolie die Isolationspaste und/oder die Isolationssuspension aufgebracht und anschließend mittels einer Druckdifferenz zwischen Ober- und Unterseite der Festelektrolytfolie durch das Durchkontaktierloch gesaugt bzw. gepresst wird. Vorteilhafterweise kann zwischen den einzelnen Saugvorgängen je eine Trocknung der Isolationspaste und/oder der Isolationssuspension erfolgen. Es ist vorgesehen, dass die Festelektrolytfolie nach dem Saugen von der ersten Seite und vor dem Saugen von der zweiten Seite gewendet wird.

Zur Realisierung einer alterungsbeständigen Durchkontaktierung ist es vorteilhaft, dass das Leitelement und das Isolationselement innig miteinander verbunden sind, was insbesondere durch ein Kosintern gewährleistet ist. Für letzteres ist es erforderlich zumindest eine oder eine Kombination mehrerer oder alle der im Anspruch 19 genannten Maßnahmen und insbesondere eine Sintertemperatur von 1350°C bis 1450°C anzuwenden.

### Zeichnung

- Figur 1: zeigt eine schematische Darstellung eines Sensorelements
- Figur 2a bis 2e: zeigen verschiedene Ausführungsformen der Erfindung
- Figur 3: zeigt schematisch die Herstellung eines Sensorelements
- Figur 4, 5a und 5b: zeigen die Herstellung der Durchkontaktierung eines Sensorelements

### Beschreibung des Ausführungsbeispiels

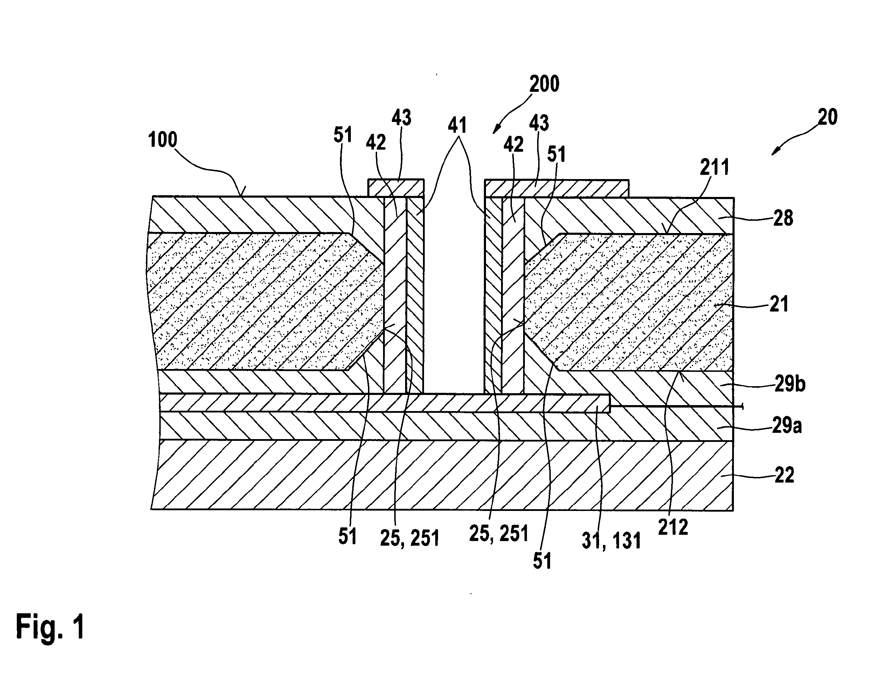

Figur 1 zeigt als ein Ausführungsbeispiel der Erfindung einen anschlussseitigen Endabschnitt eines Sensorelements 20, das in einem Gehäuse eines Gasmessfühlers (nicht gezeichnet) angeordnet ist und beispielsweise der Bestimmung der Sauerstoffkonzentration in einem Abgas eines Verbrennungsmotors (nicht gezeichnet) oder der Temperatur des Abgases dient.

Das Sensorelement 20 ist aus keramischen Schichten 21, 22, 28, 29a, 29b aufgebaut, von denen zwei als eine erste und eine zweite Festelektrolytfolie 21, 22 ausgebildet sind und Yttriumoxid stabilisiertes Zirkonoxid (YSZ) enthalten, zwei als innere elektrisch isolierende Schichten 29a, 29b ausgebildet sind und Aluminiumoxid enthalten und eine als äußere elektrisch isolierende Schichte 28 ausgebildet ist und ebenfalls Aluminiumoxid enthält.

Unterhalb und oberhalb der inneren elektrisch isolierenden Schichten 29a, 29b befinden sich die erste und die zweite Festelektrolytfolie 21, 22. Oberhalb der ersten Festelektrolytfolie 21 ist die äußere elektrisch isolierende Schicht 28 angeordnet. Selbstverständlich kann das Sensorelement 20 weitere Schichten aufweisen zur Realisierung an sich bekannter Funktionalitäten des Sensorelements 20.

Zwischen den inneren elektrisch isolierenden Schichten 29a, 29b befindet sich ein Funktionselement 31, das sich in diesem Beispiel aus einer elektrischen Widerstandsheizung und einer Zuleitung 131 zu der elektrischen Widerstandsheizung zusammensetzt. Die elektrische Widerstandsheizung bewirkt zusammen mit einer äußeren Beschaltung (nicht gezeichnet) die Beheizung des Sensorelements 20, beispielsweise auf Temperaturen bis über 650°C. Die Zuleitung 131 zu der elektrischen Widerstandsheizung erstreckt sich bis zum anschlussseitigen Endabschnitt des Sensorelements 20, während die elektrische Widerstandsheizung in dem gegenüberliegenden, in der Figur 1 nicht gezeichneten, messseitigen Endabschnitt des Sensorelements 20 angeordnet ist. Selbstverständlich kann das Funktionselement 31 auch eine andere, im Zusammenhang mit keramischen Sensorelementen an sich bekannte Funktion haben.

Das Sensorelement 20 weist im Bereich des anschlussseitigen Endabschnitts eine elektrische Durchkontaktierung 200 auf, die eine elektrische Kontaktierung des sich im Inneren des Sensorelements 20 befindlichen Funktionselements 31 über die Außenfläche 100 des Sensorelements 20 ermöglicht. Die Durchkontaktierung 200 erstreckt sich folglich ausgehend von dem Funktionselement 31 durch die innere elektrisch isolierende Schicht 29b, durch die erste Festelektrolytfolie 21 und durch die die äußere elektrisch isolierende Schicht 28 bis an die Außenfläche 100 des Sensorelements 20. Zum Zweck der Durchkontaktierung 200 weist die erste Festelektrolytschicht 21 ein Durchkontaktierloch 25 auf. Im Inneren der Durchkontaktierung 200 ist ein schichtförmig ausgebildetes Isolierelement 42 angeordnet, das sich ausgehend von der äußeren elektrisch isolierenden Schicht 28, über die Wand 251 des Durchkontaktierlochs 25 bis zur inneren elektrisch isolierenden Schicht 29b erstreckt, sodass durch das schichtförmig ausgebildete Isolierelement 42 und die äußere und innere isolierende Schicht 28, 29b die erste Festelektrolytschicht 21 im Bereich der Durchkontaktierung 200 vollständig von elektrisch isolierendem Material, das beispielsweise Aluminiumoxid enthält, umgeben ist und innerhalb der Durchkontaktierung 200 ein Bereich entsteht, der gegenüber der ersten Festelektrolytschicht 21 auch bei hohen Temperaturen, zum Beispiel Temperaturen von über 400°, elektrisch isoliert ist. In diesem elektrisch isolierten Bereich, auf dem schichtförmig ausgebildeten Isolierelement 42 ist ein ebenfalls schichtförmig ausgebildetes Leitelement 41 angeordnet, das sich ausgehend von dem Funktionselement 31 durch die Durchkontaktierung 200 bis zu einer auf der Außenfläche 100 des Sensorelements 20 angeordneten Kontaktfläche 43 erstreckt, sodass insgesamt eine elektrische Kontaktierung des sich im Inneren des Sensorelements 20 befindlichen Funktionselements 31 über die Außenfläche 100 des Sensorelements 20 entsteht, die gegenüber der ersten Festelektrolytschicht 21 elektrisch isoliert ist.

Die Wand 251 des Durchkontaktierlochs 25 weist an seiner Oberkante und an seiner Unterkante jeweils eine Fase 51 auf, die jeweils eine schräge Verbindung zwischen einer der Großflächen der ersten Festelektrolytschicht 21 und einem zu den Großflächen der ersten Festelektrolytschicht 21 senkrechten Teil der Wand 251 des Durchkontaktierlochs 25 im Inneren des Durchkontaktierlochs 25 darstellt. In den gedanklich aus der ersten Festelektrolytschicht 21 durch die Fasen 51 ausgeschnittenen, umlaufenden Bereichen befindet sich in diesem Beispiel elektrisch isolierendes Material. Dieses Material kann, wie in Figur 1 ersichtlich, als den elektrisch isolierenden Schichten 28, 29b zugehörig aufgefasst werden oder als dem Isolationselement 42 zugehörig aufgefasst werden.

In diesem Beispiel weist das Durchkontaktierloch 25 an seiner engsten Stelle einen Durchmesser auf, der im Bereich von 0,3mm bis 2mm liegt. Das schichtförmige Isolationselement 42 und das schichtförmige Leitelement 41 weisen im Inneren der Durchkontaktierung 200 Schichtdicken im Bereich von 5 bis 100µm auf. Besonders bevorzugt ist es, die Schichtdicke des Isolationselements 42 sehr homogen zu gestalten, sodass sie stets oder zumindest fast überall zwischen einer Mindestdicke und einer höchstzulässigen Dicke liegt, zum Beispiel zwischen 7µm und 26µm.

Die in der Figur 1 angegebenen Fasen 51 sind als Teil der Wand 251 des Durchkontaktierlochs 25 zu verstehen, der zwischen einer Großfläche der ersten Festelektrolytschicht 21 und einem-weiteren Teil der Wand des Durchkontaktierlochs 25 angeordnet ist, wobei die Neigung der Wand in dem weiteren Teil der Wand 251 des Durchkontaktierlochs 25 in radialer Richtung zumindest weitgehend konstant ist, und insbesondere zumindest weitgehend senkrecht zur Neigung der Großfläche der ersten Festelektrolytschicht 21 ist, wobei in dem Teil der Wand 251 des Durchkontaktierlochs 25 die Neigung der Wand 251 in radialer Richtung zwischen der Neigung der Wand 251 in radialer Richtung in dem weiteren Teil der Wand 251 des Durchkontaktierlochs 25 und der Neigung der Großfläche der ersten Festelektrolytschicht 21 liegt.

In diesem Beispiel enthält das Isolationselement 42 einen Anteil von 55 Gew-% α-Al₂O₃ und einen Anteil von 45 Gew-% einer hoch isolierende Glasphase, zum Beispiel eines Celsian-Glases oder eines Ba-Si-La-Glases. Auch andere Anteile und andere Bestandteile sind möglich.

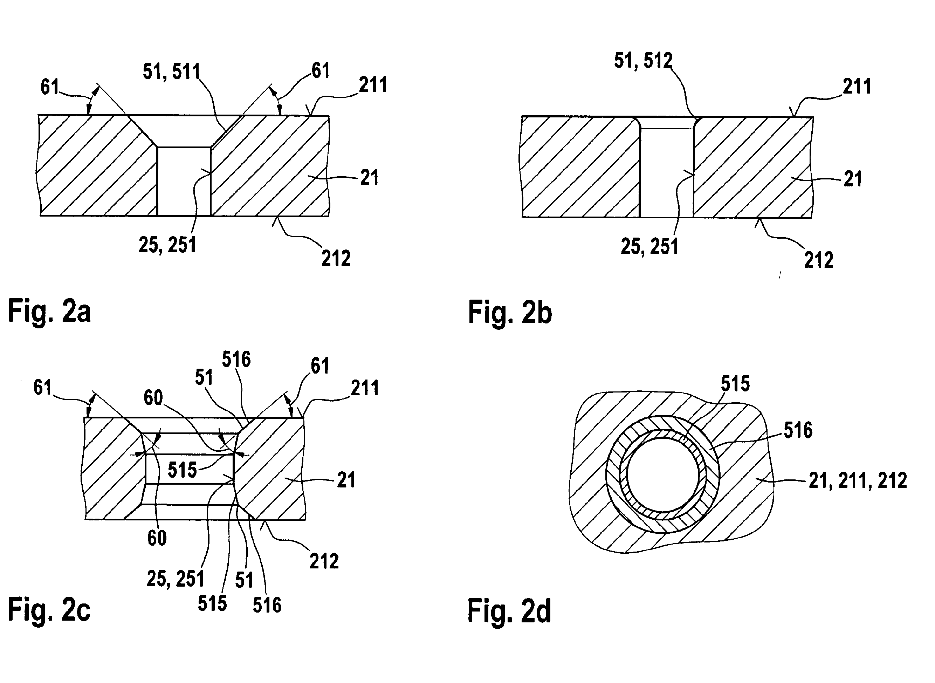

Ausführungsformen des Ausführungsbeispiels sind in den Figuren 2a bis 2e gezeigt und betreffen Weiterbildungen der Form der Fase 51 der Wand 251 des Durchkontaktierlochs 25 in der ersten Festelektrolytschicht 21. Es sind dabei in den Figuren 2a bis 2e zur besseren Übersichtlichkeit jeweils nur die erste Festelektrolytschicht 21, das Durchkontaktierloch 25 und eine oder mehrere Fasen 51 dargestellt, wobei jedoch auch diese Ausführungsformen im Sinne eines, in Figur 1 beispielhaft gezeigten, Sensorelements zu verstehen sind. Selbstverständlich sind sämtliche Ausführungsformen der Erfindung nicht auf planar aufgebaute keramische Sensorelemente eingeschränkt, sondern unmittelbar auf andere, beispielsweise zylindrische, Geometrien eines Schichtaufbaus übertragbar.

Die in Figur 2a gezeigte Fase 51 weist einen geraden Bereich 511 auf, der in radialer Richtung gerade ist und sich über die gesamte umlaufende Fase 51 erstreckt. Die Fase 51 erstreckt sich bis in eine Tiefe von 100µm der ersten Festelektrolytschicht 21 bei einer Dicke der ersten Festelektrolytschicht 21 von 400µm. Die Fase 51 weist bezüglich der Großflächen der ersten Festelektrolytschicht 21 eine Neigung von 45° auf, d.h. der gerade Bereich 511 der Fase 51 schließt mit den Großflächen der ersten Festelektrolytschicht 21 einen Winkel 61 von 45° ein.

Die in Figur 2b gezeigte Fase 51 weist einen gekrümmten Bereich 512 auf, der in radialer Richtung abgerundet ist. Der gekrümmte Bereich weist in radialer Richtung einen Krümmungsradius von 80µm auf. Die Fase 51 erstreckt sich bis in eine Tiefe von 80µm der ersten Festelektrolytschicht 21 bei einer Dicke der ersten Festelektrolytschicht 21 von 400µm.

Die in den Figuren 2c und 2d gezeigten Fasen 51 bestehen jeweils aus einer ersten Teilfase 515 und einer zweiten Teilfase 516. In Aufsicht auf die Festelektrolytfolie 21 (Figur 2d) ist die erste Teilfase 515 innerhalb der zweiten Teilphase 516 angeordnet. Die beiden Teilfasen 515 und 516 stoßen in radialer Richtung unter einem Teilfasenwinkel 60 von 37,5° aufeinander. Die zweite Teilfase 516 ist gegenüber der Großfläche der Festelektrolytschicht um 22,5° geneigt.

Die zweite Teilfase 516 ist zwischen einer Großfläche der Festelektrolytschicht 21 und der ersten Teilfase 515 angeordnet und die Neigung der Wand 251 in radialer Richtung liegt in der zweiten Teilfase 516 zwischen der Neigung der Wand 251 in radialer Richtung in der ersten Teilfase 515 und der Neigung der Großfläche der Festelektrolytschicht 21.

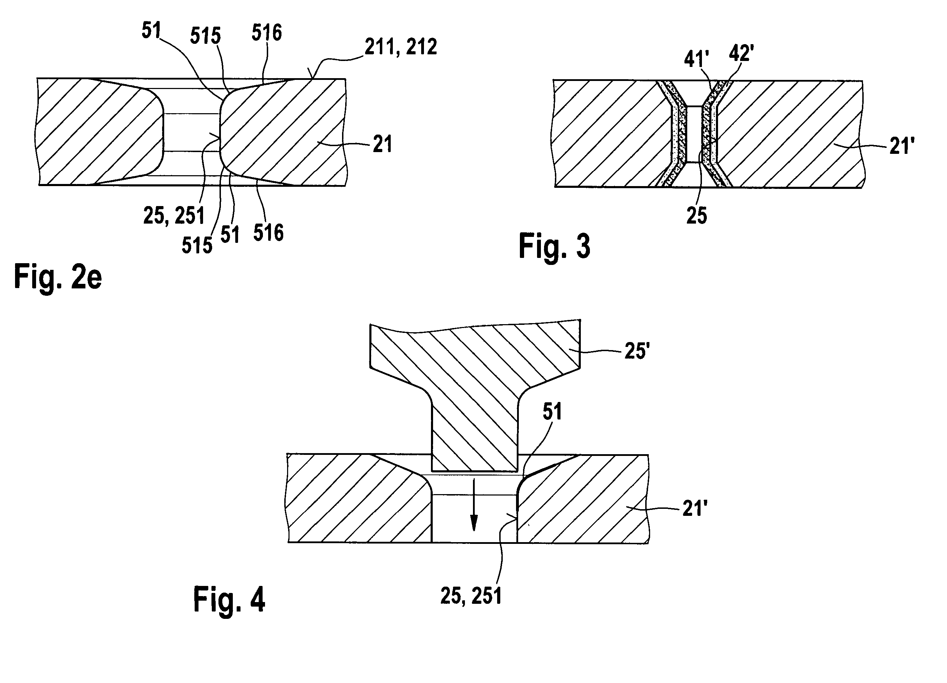

Die in der Figur 2e gezeigten Fasen 51 bestehen jeweils aus einer ersten Teilfase 515 und einer zweiten Teilfase 516. In Aufsicht auf die Festelektrolytfolie 21 ist die erste Teilfase 515 innerhalb der zweiten Teilphase 516 angeordnet (wie Figur 2d). Die beiden Teilfasen 515 und 516 gehen ohne Kante, plan ineinander über. Die zweite Teilfase 516 ist eine in radialer Richtung gerade und gegenüber der Großfläche der Festelektrolytschicht um 9,3° geneigt. Die zweite Teilfase 516 erstreckt sich bis in eine Tiefe von 38 µm in das Durchkontaktierloch 25, etwa 10% der Dicke der ersten Festelektrolytschicht 21. Die erste Teilfase 515 ist in radialer Richtung gekrümmt, wobei die Krümmung einen Radius von 55µm aufweist.

Auch weitere Kombinationen der Merkmale der dargestellten Fasen 51 sind denkbar.

Die Herstellung eines erfindungsgemäßen Sensorelements 10, insbesondere einer Durchkontaktierung 200 eines solchen Sensorelements 20 ist in Figur 3 beispielhaft schematisch dargestellt und kann erfolgen, indem in eine ungebrannte Festelektrolytfolie 21', zum Beispiel aus mit Y, Ca und/oder mit Sc stabilisiertem ZrO₂, ein Durchkontaktierloch 25 durch Stanzen, Prägen und/oder ein- oder zweiseitiges Bohren, insbesondere mittels Laserstrahlung, eingebracht wird. Nachfolgend erfolgt ein ein- oder mehrfaches Einbringen einer Isolationspaste 42' und/oder einer Isolationssuspension in das Durchkontaktierloch 25 durch Drucken, Siebdrucken, ein- oder zweiseitiges Saugen/Pressen, Sprühen und/oder Tropfen, wobei abschließend, und bei mehrfachem Einbringen zusätzlich auch zwischenzeitlich, eine Trocknung erfolgt. Nachfolgend erfolgt ein ein- oder mehrfaches Einbringen einer Leitpaste 41' in das Durchkontaktierloch 25 durch Durchsaugen der Leitpaste 41' durch das Durchkontaktierloch 25 und/oder durch Aufdrucken der Leitpaste 41' auf die Oberfläche der Festelektrolytfolie 21'.

In einer Ausführungsform wird zur Herstellung eines erfindungsgemäßen Sensorelements 10, insbesondere zum Einbringen eines Durchkontaktierlochs 25 in die Festelektrolytfolie 21', ein spezielles Werkzeug 25' benutzt, das als mechanischer Bohrer oder als Stanzwerkzeug ausgebildet ist, siehe Figur 4. Die Form des Stanzwerkzeugs oder die sich bei Rotation des Bohrers ausbildende Schneidfläche ist im unteren, distalen Teilbereich zylindrisch, im sich nach oben anschließenden, proximalen Teilbereich des Werkzeugs 25' entspricht sie der Form der herzustellenden Fase 51. Es ist auch möglich, mit diesem speziellen Werkzeug 25' nur Teile des Durchkontaktierlochs 25, zum Beispiel nur den Bereich, der die Fase 51 aufweist, zu fertigen und die übrige Bohrung auf eine andere Art und Weise herzustellen. In diesem Fall würde der untere, distale, zylindrische Teil des Werkzeugs 25' wegfallen.

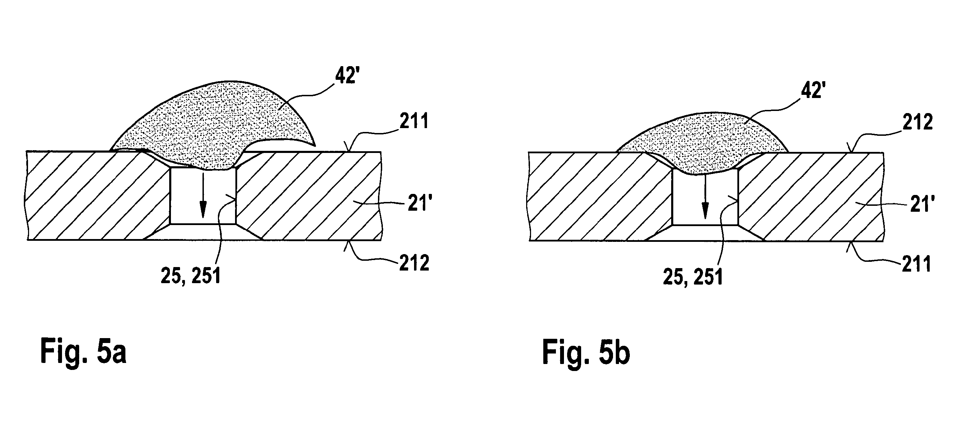

In einer anderen Ausführungsform wird zusätzlich oder alternativ zur Herstellung eines erfindungsgemäßen Sensorelements 10, insbesondere zum Einbringen einer Isolationspaste 42' und/oder einer Isolationssuspension in das Durchkontaktierloch 25 zunächst Isolationspaste 42' auf der Oberseite 211 der Festelektrolytfolie 21' im Bereich des Durchkontaktierlochs 25 aufgebracht, siehe Figur 5a. Es ist vorgesehen, dass diese Isolationspaste 42' durch Anlegen eines Unterdrucks auf der Unterseite 212 der Festelektrolytfolie 21' in das Durchkontaktierloch hineingesaugt wird, sodass es zu einer Beschichtung der Wand 251 der Durchkontaktierung kommt.

Es ist ferner vorgesehen, das Aufbringen und Durchsaugen nach einem Wenden der Festelektrolytfolie 21' ein oder mehrfach zu wiederholen, wobei die Isolationspaste 42' nun auf der in Figur 5b nach oben weisenden Unterseite 212 der Festelektrolytfolie 21' im Bereich des Durchkontaktierlochs 25 aufgebracht wird und mittels Unterdruck in Richtung der nun in Figur 5b nach unten weisenden Oberseite 211 der Festelektrolytfolie 21' durchgesaugt wird.

Es ist in einer weiteren bevorzugten Ausführungsform zusätzlich oder alternativ vorgesehen, dass der Unterdruck, eine Konsistenz der Isolationspaste 42' sowie die Anzahl der Durchsaugungen und die Form des Durchkontaktierlochs 25 so gewählt werden, dass entlang der gesamten Wand 251 des Durchkontaktierlochs 25 eine Schicht der Isolationspaste 42' und/oder der Isolationssuspension erzeugt wird, deren Dicke 5µm bis 35µm, insbesondere 10µm bis 25µm, beträgt.

Es ist in einer weiteren bevorzugten Ausführungsform zusätzlich oder alternativ vorgesehen, dass zur Herstellung eines Sensorelements 10, insbesondere einer Durchkontaktierung 200 eines solchen Sensorelements 20 ein Sintern, insbesondere bei 1350°C bis 1450°C, vorgesehen ist. Um zu gewährleisten, dass im Anschluss das Leitelement 41 und das Isolationselement als kogesinterter Verbund vorliegen, wird hierbei eine der folgenden Maßnahmen angewendet oder es wird eine Kombination der folgenden Maßnahmen angewendet oder es werden alle der folgenden Maßnahmen angewendet:
- Die Isolationspaste 42' und/oder die Isolationssuspension weist Partikel eines Isolationsmaterials, insbesondere Aluminiumoxid, auf und ferner organische Bestandteile, insbesondere Weichmacher, Lösungsmittel und Binder, und die Leitpaste 41' weist Partikel eines Edelmetalls, insbesondere Platin, auf und weist Partikel eines Festelektrolyts, insbesondere YSZ, auf und ferner organische Bestandteile, insbesondere Weichmacher, Lösungsmittel und Binder.
- Die Größe (d₉₀) der Partikel des Isolationsmaterials, die Größe (d₉₀) der Partikel des Edelmetalls und die Größe (d₉₀) der Partikel des Festelektrolyts liegen alle im Bereich von 0,8µm bis 2,5µm.
- Die Größe (d₉₀) der Partikel des Isolationsmaterials, die Größe (d₉₀) der Partikel des Edelmetalls und die Größe (d₉₀) der Partikel des Festelektrolyts unterscheiden sich um weniger als 50% des größten der drei Werte.
- Der Feststoffgehalt (Gew-%) in der Isolationspaste 42' und/oder in der Isolationssuspension unterscheidet sich von dem Feststoffgehalt (Gew-%) in der Leitpaste 42' um weniger als 20 Gew-%.
- Der Gehalt (Gew-%) an organischen Bestandteilen unterscheidet sich in der Isolationspaste 42' und/oder in der Isolationssuspension von dem Gehalt (Gew-%) an organischen Bestandteilen in der Leitpaste 42' um weniger als 20 Gew-%.
- Die Isolationspaste (42') und/oder die Isolationssuspension und die Leitpaste 41' enthalten dieselben organischen Bestandteile.

## Patentansprüche

1. Sensorelement, insbesondere zum Nachweis einer physikalischen Eigenschaft eines Gases, insbesondere zum Nachweis der Konzentration einer Gaskomponente oder der Temperatur eines Abgases eines Verbrennungsmotors, wobei das Sensorelement (20) eine erste Festelektrolytschicht (21) aufweist, wobei die erste Festelektrolytschicht (21) ein Durchkontaktierloch (25) aufweist, wobei das Sensorelement (20) ferner ein Leitelement (41) aufweist, das eine elektrisch leitende Verbindung von der Oberseite (211) der ersten Festelektrolytschicht (21) zur Unterseite (212) der ersten Festelektrolytschicht (21) durch das Durchkontaktierloch (25) herstellt, und wobei die erste Festelektrolytschicht (21) in dem Durchkontaktierloch (25) von dem Leitelement (41) durch ein Isolationselement (42) elektrisch isoliert ist, **dadurch gekennzeichnet, dass** die Wand (251) des Durchkontaktierlochs (25) in der ersten Festelektrolytschicht (21) eine Fase (51) aufweist.

2. Sensorelement nach Anspruch 1, **dadurch gekennzeichnet, dass** die Fase (51) bis in eine Tiefe von nicht weniger als 25µm, insbesondere von nicht weniger als 75µm, in das Durchkontaktierloch (25) reicht und/oder dass die Fase (51) bis in eine Tiefe von nicht weniger als 5% der Dicke der ersten Festelektrolytschicht (21), insbesondere von nicht weniger als 15% der Dicke der ersten Festelektrolytschicht (21), in das Durchkontaktierloch (25) reicht.

3. Sensorelement nach einem der Ansprüche 1 bis 2, **dadurch gekennzeichnet, dass** die Fase (51) zumindest einen geraden Bereich (511) aufweist, der in radialer Richtung gerade ist, wobei sich der gerade Bereich (511) der Fase (51) insbesondere über die gesamte Fase (51) erstreckt.

4. Sensorelement nach Anspruch 3, **dadurch gekennzeichnet, dass** der gerade Bereich (511) der Fase (51) mit der Oberseite (211) der ersten Festelektrolytschicht (21) und/oder der Unterseite (212) der ersten Festelektrolytschicht (21) einen Winkel (61) von nicht weniger als 15° und von nicht mehr als 75°, insbesondere von nicht weniger als 30° und von nicht mehr als 60°, einschließt.

5. Sensorelement nach einem der Ansprüche 1 bis 4, **dadurch gekennzeichnet, dass** die Fase (51) zumindest einen gekrümmten Bereich (512) aufweist, der in radialer Richtung abgerundet ist, insbesondere mit einem Krümmungsradius von 10µm bis 200µm, insbesondere von 25µm bis 115µm, wobei sich der gekrümmte Bereich (512) der Fase (51) insbesondere über die gesamte Fase (51) erstreckt.

6. Sensorelement nach einem der Ansprüche 1 bis 5, **dadurch gekennzeichnet, dass** die Fase (51) eine erste Teilfase (515) und eine zweite Teilfase (516) aufweist, wobei die zweite Teilfase (516) zwischen einer Großfläche der Festelektrolytschicht (21) und der ersten Teilfase (515) angeordnet ist, wobei in der zweiten Teilfase (516) eine Neigung der Wand (251) in radialer Richtung zwischen einer Neigung der Wand (251) in radialer Richtung in der ersten Teilfase (515) und der Neigung der Großfläche der Festelektrolytschicht (21) liegt.

7. Sensorelement nach einem der Ansprüche 5 oder 6, **dadurch gekennzeichnet, dass** die zweite Teilfase (516) bis in eine Tiefe von nicht weniger als 10µm, insbesondere von nicht weniger als 30µm, in das Durchkontaktierloch (25) reicht und/oder bis in eine Tiefe von nicht weniger als 2,5% der Dicke der ersten Festelektrolytschicht (21), insbesondere von nicht weniger als 7,5% der Dicke der ersten Festelektrolytschicht (21), in das Durchkontaktierloch (25) reicht und/oder wobei die zweite Teilfase (516) bis in eine Tiefe von nicht mehr als 100µm, insbesondere von nicht mehr als 50µm, in das Durchkontaktierloch (25) reicht und/oder bis in eine Tiefe von nicht mehr als 20% der Dicke der ersten Festelektrolytschicht (21), insbesondere von nicht mehr als 10% der Dicke der ersten Festelektrolytschicht (21), in das Durchkontaktierloch (25) reicht.

8. Sensorelement nach einem der Ansprüche 5 bis 7, **dadurch gekennzeichnet, dass** die erste Teilfase (515) und die zweite Teilfase (516) jeweils in radialer Richtung zumindest bereichsweise gerade sind und in radialer Richtung unter einem Teilfasenwinkel (60) aufeinanderstoßen, insbesondere unter einem Teilfasenwinkel (60) von nicht weniger als 10° und von nicht mehr als 55°, insbesondere unter einem Teilfasenwinkel (60) von nicht weniger als 25° und von nicht mehr als 45°.

9. Sensorelement nach einem der Ansprüche 5 bis 8, **dadurch gekennzeichnet, dass** die zweite Teilfase (516) mit der Oberseite (211) der Festelektrolytschicht (21) und/oder der Unterseite (212) der ersten Festelektrolytschicht (21) einen Winkel (61) von nicht weniger als 3° und von nicht mehr als 25°, insbesondere von nicht weniger als 6° und von nicht mehr als 16°, einschließt.

10. Sensorelement nach einem der Ansprüche 5 bis 9, **dadurch gekennzeichnet, dass** die zweite Teilfase (516) in radialer Richtung zumindest bereichsweise gerade ist und die erste Teilfase (515) in radialer Richtung zumindest bereichsweise abgerundet ist, insbesondere mit einem Krümmungsradius von 10µm bis 200µm, insbesondere mit einem Krümmungsradius von 25µm bis 115µm, wobei insbesondere die zweite Teilfase (516) und die erste Teilfase (515) in radialer Richtung unter einem Teilfasenwinkel (60) von weniger als 5°, insbesondere weniger als 1°, insbesondere plan, aufeinanderstoßen.

11. Sensorelement nach einem der Ansprüche 1 bis 10, **dadurch gekennzeichnet, dass** die Wand (251) des Durchkontaktierlochs (25) an der Unter- und an der Oberkante des Durchkontaktierlochs (25) jeweils eine Fase (51) aufweist.

12. Sensorelement nach einem der Ansprüche Anspruch 1 bis 11, **dadurch gekennzeichnet, dass** das Isolationselement (42) schichtförmig auf der Wand (251) des Durchkontaktierlochs (25) angeordnet ist und entlang mindestens 90% der Wand (251) des Durchkontaktierlochs (25), insbesondere entlang mindestens 97% der Wand (251) des Durchkontaktierlochs (25), eine Schichtdicke aufweist, die zwischen einer Mindestschichtdicke und einer höchstzulässigen Dicke liegt, wobei die Mindestdicke im Bereich zwischen 5µm und 14 µm liegt und zum Beispiel 10µm beträgt, und die höchstzulässige Dicke im Bereich zwischen 16µm und 30µm liegt und zum Beispiel 20µm beträgt.

13. Sensorelement nach einem der Ansprüche Anspruch 1 bis 12, **dadurch gekennzeichnet, dass** das Isolationselement (42) zumindest eines oder beide der folgenden Materialien aufweist:
- Al₂O₃, insbesondere α-Al₂O₃, insbesondere mit einem Anteil von mehr als 50 Gew-%
- eine Glasphase, insbesondere eine hochisolierende Glasphase, zum Beispiel eines Celsian-Glases oder eines Ba-Si-La-Glas, insbesondere mit einem Anteil von weniger als 50 Gew-%.

14. Verfahren zur Herstellung eines Sensorelements (20) nach einem der voranstehenden Ansprüche, **dadurch gekennzeichnet, dass** das Verfahren die folgenden Schritte, insbesondere in der genannten Reihenfolge, vorsieht:
- Herstellen einer ungebrannten Festelektrolytfolie (21'), z.B. aus mit Y, Ca und/oder mit Sc stabilisiertem ZrO₂,
- Einbringen eines Durchkontaktierloches (25) in die Festelektrolytfolie (21') durch Stanzen, Prägen oder ein- oder zweiseitiges Bohren, insbesondere mittels mechanischem Bohrer oder mittels Laserstrahlung,
- Ein- oder mehrfaches Einbringen einer Isolationspaste (42') und/oder einer Isolationssuspension in das Durchkontaktierloch (25) durch Drucken, Siebdrucken, einseitiges oder zweiseitiges Saugen/Pressen, Sprühen und/oder Tropfen, wobei abschließend, und bei mehrfachem Einbringen zusätzlich insbesondere auch zwischenzeitlich, eine Trocknung erfolgt,
- Ein- oder mehrfaches Einbringen einer Leitpaste (41') in das Durchkontaktierloch (25) durch Durchsaugen der Leitpaste (41) durch das Durchkontaktierloch (25) und/oder durch Aufdrucken der Leitpaste (41) auf die Oberfläche der Festelektrolytfolie (21'),
- Sintern des Sensorelements (20), wobei es zum Kosintern der Leitpaste (41') und der Isolationspaste (42') und/oder der Isolationssuspension kommt und/oder wobei es zum Kosintern der Festelektrolytfolie (21') und der Isolationspaste (42') und/oder der Isolationssuspension kommt.

15. Verfahren nach Anspruch 14, **dadurch gekennzeichnet, dass** das Einbringen des Durchkontaktierlochs (25) mit einem oder mehreren Werkzeugen (25'), insbesondere einem oder mehreren mechanischen Bohrern und/oder Stanzwerkzeugen, erfolgt, wobei zumindest ein Teilbereich der Werkzeuge (25') eine Form aufweist, die im Wesentlichen der Form des einzubringenden Durchkontaktierlochs (25) entspricht oder der im Wesentlichen der Form von zumindest einem Teilbereich des einzubringenden Durchkontaktierlochs (25) entspricht.

16. Verfahren nach Anspruch 14 oder 15, wobei das Einbringen einer Isolationspaste (42') und/oder einer Isolationssuspension in das Durchkontaktierloch (25) durch zweiseitiges Saugen erfolgt und folgende Teilschritte, insbesondere in der genannten Reihenfolge, vorsieht:
- Aufbringen der Isolationspaste (42') und/oder der Isolationssuspension auf der Oberseite (211) der Festelektrolytfolie (21') im Bereich des Durchkontaktierlochs (25)
- Durchsaugensaugen der Isolationspaste (42') und/oder der Isolationssuspension durch das Durchkontaktierloch (25) durch Erzeugen eines Unterdrucks auf der Unterseite (212) der Festelektrolytfolie (21') im Bereich des Durchkontakberlochs (25)
- Aufbringen der Isolafionspaste (42') und/oder der Isolationssuspension auf der Unterseite (212) der Festelektrolytfolie (21') im Bereich des Durchkontaktierlochs (25)
- Durchsaugensaugen der Isolationspaste (42') und/oder der Isolationssuspension durch das Durchkontaktierloch (25) durch Erzeugen eines Unterdrucks auf der Oberseite (212) der Festelektrolytfolie (21') im Bereich des Durchkontaktierlochs (25).

17. Verfahren nach Anspruch 16, **dadurch gekennzeichnet, dass** der Unterdruck, eine Konsistenz der Isolationspaste (42') und/oder der Isolafionssuspension sowie die Anzahl und Richtungen der Durchsaugungen und die Form des Durchkontaktierlochs (25) so gewählt werden, dass entlang der gesamten Wand (251) des Durchkontaktierlochs (25) eine Schicht der Isolationspaste (42') und/oder der Isolationssuspension erzeugt wird, deren Dicke 5µm bis 35µm, insbesondere 10µm bis 25µm, beträgt.

18. Verfahren nach einem der Ansprüche 14 bis 17, **dadurch gekennzeichnet, dass** die Isolationspaste (42') und/oder die Isolationssuspension Partikel eines Isolationsmaterials, insbesondere Aluminiumoxid aufweist und ferner organische Bestandteile, insbesondere Weichmacher, Lösungsmittel und Binder aufweist und dass die Leitpaste (41') Partikel eines Edelmetalls, insbesondere Platin, aufweist und Partikel eines Festelektrolyts, insbesondere YSZ, aufweist und ferner organische Bestandteile, insbesondere Weichmacher, Lösungsmittel und Binder aufweist, wobei zumindest eine der folgenden Bedingungen erfüllt ist:
- Die Größe (d₉₀) der Partikel des Isolationsmaterials, die Größe (d₉₀) der Partikel des Edelmetalls und die Größe (d₉₀) der Partikel des Festelektrolyts liegen alle im Bereich von 0,8µm bis 2,5µm.
- Die Größe (d₉₀) der Partikel des Isolationsmaterials, die Größe (d₉₀) der Partikel des Edelmetalls und die Größe (d₉₀) der Partikel des Festelektrolyts unterscheiden sich um weniger als 50% des größten der drei Werte.
- Der Feststoffgehalt (Gew-%) in der Isolationspaste (42') und/oder in der Isolationssuspension unterscheidet sich von dem Feststoffgehalt (Gew-%) in der Leitpaste (42') um weniger als 20 Gew-%.
- Der Gehalt (Gew-%) an organischen Bestandteilen unterscheidet sich in der Isolationspaste (42') und/oder in der Isolafionssuspension von dem Gehalt (Gew-%) an organischen Bestandteilen in der Leitpaste (42') um weniger als 20 Gew-%.
- Die Isolationspaste (42') und/oder die Isolationssuspension und die Leitpaste (41') enthalten dieselben organischen Bestandteile.

19. Verfahren nach Anspruch 18, wobei alle genannten Bedingungen erfüllt sind.

## Claims

1. Sensor element, in particular for detecting a physical property of a gas, in particular for detecting the concentration of a gas component or the temperature of an exhaust gas of an internal combustion engine, the sensor element (20) comprising a first solid electrolyte layer (21), the first solid electrolyte layer (21) comprising an interlayer connection hole (25), the sensor element (20) further comprising a conducting element (41), which establishes an electrically conductive connection from the upper side (211) of the first solid electrolyte layer (21) to the underside (212) of the first solid electrolyte layer (21) through the interlayer connection hole (25), and the first solid electrolyte layer (21) being electrically insulated from the conducting element (41) by an insulating element (42) in the interlayer connection hole (25), **characterized in that** the wall (251) of the interlayer connection hole (25) in the first solid electrolyte layer (21) has a bevel (51).

2. Sensor element according to Claim 1, **characterized in that** the bevel (51) reaches into the interlayer connection hole (25) to a depth of not less than 25 µm, in particular of not less than 75 µm, and/or **in that** the bevel (51) reaches into the interlayer connection hole (25) to a depth of not less than 5% of the thickness of the first solid electrolyte layer (21), in particular of not less than 15% of the thickness of the first solid electrolyte layer (21).

3. Sensor element according to either of Claims 1 and 2, **characterized in that** the bevel (51) has at least one straight region (511), which is straight in the radial direction, the straight region (511) of the bevel (51) extending in particular over the entire bevel (51).

4. Sensor element according to Claim 3, **characterized in that** the straight region (511) of the bevel (51) forms an angle (61) with the upper side (211) of the first solid electrolyte layer (21) and/or the underside (212) of the first solid electrolyte layer (21) of not less than 15° and of not more than 75°, in particular of not less than 30° and of not more than 60°.

5. Sensor element according to one of Claims 1 to 4, **characterized in that** the bevel (51) has at least one curved region (512), which is rounded off in the radial direction, in particular with a radius of curvature of 10 µm to 200 µm, in particular of 25 µm to 115 µm, the curved region (512) of the bevel (51) extending in particular over the entire bevel (51).

6. Sensor element according to one of Claims 1 to 5, **characterized in that** the bevel (51) has a first partial bevel (515) and a second partial bevel (516), the second partial bevel (516) being arranged between a large area of the solid electrolyte layer (21) and the first partial bevel (515), an inclination of the wall (251) in the radial direction in the second partial bevel (516) lying between an inclination of the wall (251) in the radial direction in the first partial bevel (515) and the inclination of the large area of the solid electrolyte layer (21).

7. Sensor element according to either of Claims 5 and 6, **characterized in that** the second partial bevel (516) reaches into the interlayer connection hole (25) to a depth of not less than 10 µm, in particular of not less than 30 µm, and/or reaches into the interlayer connection hole (25) to a depth of not less than 2.5% of the thickness of the first solid electrolyte layer (21), in particular of not less than 7.5% of the thickness of the first solid electrolyte layer (21), and/or the second partial bevel (516) reaches into the interlayer connection hole (25) to a depth of not more than 100 µm, in particular of not more than 50 µm, and/or reaches into the interlayer connection hole (25) to a depth of not more than 20% of the thickness of the first solid electrolyte layer (21), in particular of not more than 10% of the thickness of the first solid electrolyte layer (21).

8. Sensor element according to one of Claims 5 to 7, **characterized in that** the first partial bevel (515) and the second partial bevel (516) are each straight at least in places in the radial direction and butt against one another in the radial direction at a partial bevel angle (60), in particular at a partial bevel angle (60) of not less than 10° and of not more than 55°, in particular at a partial bevel angle (60) of not less than 25° and of not more than 45°.

9. Sensor element according to one of Claims 5 to 8, **characterized in that** the second partial bevel (516) forms an angle (61) with the upper side (211) of the solid electrolyte layer (21) and/or the underside (212) of the first solid electrolyte layer (21) of not less than 3° and of not more than 25°, in particular of not less than 6° and of not more than 16°.

10. Sensor element according to one of Claims 5 to 9, **characterized in that** the second partial bevel (516) is straight at least in places in the radial direction and the first partial bevel (515) is rounded off at least in places in the radial direction, in particular with a radius of curvature of 10 µm to 200 µm, in particular with a radius of curvature of 25 µm to 115 µm, the second partial bevel (516) and the first partial bevel (515) butting against one another in the radial direction at a partial bevel angle (60) of less than 5°, in particular less than 1°, in particular flush.

11. Sensor element according to one of Claims 1 to 10, **characterized in that** the wall (251) of the interlayer connection hole (25) has a bevel (51) respectively on the lower edge and on the upper edge of the interlayer connection hole (25).

12. Sensor element according to one of Claims 1 to 11, **characterized in that** the insulating element (42) is arranged in the form of a layer on the wall (251) of the interlayer connection hole (25) and has along at least 90% of the wall (251) of the interlayer connection hole (25), in particular along at least 97% of the wall (251) of the interlayer connection hole (25), a layer thickness which lies between a minimum layer thickness and a maximum admissible thickness, the minimum thickness lying in the range between 5 µm and 14 µm and being for example 10 µm, and the maximum admissible thickness lying in the range between 16 µm and 30 µm and being for example 20 µm.

13. Sensor element according to one of Claims 1 to 12, **characterized in that** the insulating element (42) comprises at least one or both of the following materials:
- Al₂O₃, in particular α-Al₂O₃, in particular with a proportion of more than 50% by weight,
- a glass phase, in particular a highly insulating glass phase, for example of a celsian glass or of a Ba-Si-La glass, in particular with a proportion of less than 50% by weight.

14. Method for producing a sensor element (20) according to one of the preceding claims, **characterized in that** the method provides the following steps, in particular in the stated sequence:
- producing an unfired solid electrolyte film (21'), for example from ZrO₂ stabilized with Y, Ca and/or with Sc,
- introducing an interlayer connection hole (25) into the solid electrolyte film (21') by punching, stamping or drilling from one side or from two sides, in particular by means of a mechanical drill or by means of laser radiation,
- introducing an insulating paste (42') and/or an insulating suspension one or more times into the interlayer connection hole (25) by printing, screen printing, sucking/pressing from one side or from two sides, spraying and/or dripping, while finally carrying out drying, and, in the case of introduction a number of times, in particular also carrying out drying additionally in between times,
- introducing a conductive paste (41') one or more times into the interlayer connection hole (25) by sucking the conductive paste (41') through the interlayer connection hole (25) and/or by printing the conductive paste (41') onto the surface of the solid electrolyte film (21'),
- sintering the sensor element (20), involving co-sintering of the conductive paste (41') and the insulating paste (42') and/or the insulating suspension and/or involving co-sintering of the solid electrolyte film (21') and the insulating paste (42') and/or the insulating suspension.

15. Method according to Claim 14, **characterized in that** the introduction of the interlayer connection hole (25) is performed by means of one or more tools (25'), in particular one or more mechanical drills and/or punching tools, at least a partial region of the tools (25') having a shape that corresponds substantially to the shape of the interlayer connection hole (25) to be introduced and/or that corresponds substantially to the shape of at least a partial region of the interlayer connection hole (25) to be introduced.

16. Method according to Claim 14 or 15, the introduction of an insulating paste (42') and/or an insulating suspension into the interlayer connection hole (25) being performed by sucking from two sides and providing the following partial steps, in particular in the stated sequence:
- applying the insulating paste (42') and/or the insulating suspension on the upper side (211) of the solid electrolyte film (21') in the region of the interlayer connection hole (25),
- sucking the insulating paste (42') and/or the insulating suspension through the interlayer connection hole (25) by generating a negative pressure on the underside (212) of the solid electrolyte film (21') in the region of the interlayer connection hole (25),
- applying the insulating paste (42') and/or the insulating suspension on the underside (212) of the solid electrolyte film (21') in the region of the interlayer connection hole (25),
- sucking the insulating paste (42') and/or the insulating suspension through the interlayer connection hole (25) by generating a negative pressure on the upper side (212) of the solid electrolyte film (21') in the region of the interlayer connection hole (25).

17. Method according to Claim 16, **characterized in that** the negative pressure, a consistency of the insulating paste (42') and/or of the insulating suspension and also the number and directions of the sucking-through operations and the shape of the interlayer connection hole (25) are chosen such that a layer of the insulating paste (42') and/or the insulating suspension of a thickness of 5 µm to 35 µm, in particular 10 µm to 25 µm, is produced along the entire wall (251) of the interlayer connection hole (25).

18. Method according to one of Claims 14 to 17, **characterized in that** the insulating paste (42') and/or the insulating suspension comprises particles of an insulating material, in particular aluminium oxide, and further comprises organic constituents, in particular plasticizers, solvents and binders, and **in that** the conductive paste (41') comprises particles of a noble metal, in particular platinum, and particles of a solid electrolyte, in particular YSZ, and further comprises organic constituents, in particular plasticizers, solvents and binders, at least one of the following conditions being satisfied:
- the size (d₉₀) of the particles of the insulating material, the size (d₉₀) of the particles of the noble metal and the size (d₉₀) of the particles of the solid electrolyte all lie in the range from 0.8 µm to 2.5 µm,
- the size (d₉₀) of the particles of the insulating material, the size (d₉₀) of the particles of the noble metal and the size (d₉₀) of the particles of the solid electrolyte differ by less than 50% of the greatest of the three values,
- the solids content (% by weight) in the insulating paste (42') and/or in the insulating suspension differs from the solids content (% by weight) in the conductive paste (42') by less than 20% by weight,
- the content (% by weight) of organic constituents in the insulating paste (42') and/or in the insulating suspension differs from the content (% by weight) of organic constituents in the conductive paste (42') by less than 20% by weight,
- the insulating paste (42') and/or the insulating suspension and the conductive paste (41') contain the same organic constituents.

19. Method according to Claim 18, all of the stated conditions being satisfied.

## Revendications

1. Elément de détection et en particulier destiné à détecter une propriété physique d'un gaz et en particulier à détecter la concentration d'un composant gazeux ou la température des gaz d'échappement d'un moteur à combustion interne,
l'élément de détection (20) présentant une première couche (21) d'électrolyte solide, la première couche (21) d'électrolyte solide présentant une perforation (25) de mise en contact,
l'élément de détection (20) présentant en outre un élément conducteur (41) qui établit une liaison électriquement conductrice entre le côté supérieur (211) de la première couche (21) d'électrolyte solide et le côté inférieur (212) de la première couche (21) d'électrolyte solide à travers la perforation (25) de mise en contact et
un élément isolant (42) isolant électriquement la première couche (21) d'électrolyte solide de l'élément conducteur (41) dans la perforation (25) de mise en contact,
**caractérisé en ce que**
la paroi (251) de la perforation (25) de mise en contact de la première couche (21) d'électrolyte solide présente un chanfrein (51).

2. Elément de détection selon la revendication 1, **caractérisé en ce que** le chanfrein (51) s'étend dans la perforation (25) de mise en contact jusqu'à une profondeur non inférieure à 25 µm et en particulier non inférieure à 75 µm et/ou **en ce que** le chanfrein (51) s'étend dans la perforation (25) de mise en contact jusqu'à une profondeur non inférieure à 5 % de l'épaisseur de la première couche (21) d'électrolyte solide et en particulier non inférieure à 15 % de l'épaisseur de la première couche (21) d'électrolyte solide.

3. Elément de détection selon l'une des revendications 1 et 2, **caractérisé en ce que** le chanfrein (51) présente au moins une partie rectiligne (511) en ligne droite dans la direction radiale, la partie rectiligne (511) du chanfrein (51) s'étendant en particulier sur la totalité du chanfrein (51).

4. Elément de détection selon la revendication 3, **caractérisé en ce qu'**avec le côté supérieur (211) de la première couche (21) d'électrolyte solide et/ou avec le côté inférieur (212) de la première couche (21) d'électrolyte solide, la partie rectiligne (511) du chanfrein (51) forme un angle (61) qui n'est pas inférieur à 15° et qui n'est pas supérieur à 75° et en particulier qui n'est pas inférieur à 30 ° et qui n' est pas supérieur à 60°.

5. Elément de détection selon l'une des revendications 1 à 4, **caractérisé en ce que** le chanfrein (51) présente au moins une partie courbe (512) arrondie dans la direction radiale et en particulier à un rayon de courbure de 10 µm à 200 µm et en particulier de 25 µm à 115 µm, la partie courbe (512) du chanfrein (51) s'étendant en particulier sur la totalité du chanfrein (51).

6. Elément de détection selon l'une des revendications 1 à 5, **caractérisé en ce que** le chanfrein (51) présente une première partie (515) de chanfrein et une deuxième partie (516) de chanfrein, la deuxième partie (516) de chanfrein étant disposée entre la surface principale de la couche (21) d'électrolyte solide et la première partie (515) de chanfrein, la pente de la paroi (251) dans la direction radiale entre la pente de la paroi (251) dans la direction radiale de la première partie (515) de chanfrein et la pente de la surface principale de la couche (21) d'électrolyte solide étant située dans la deuxième partie (516) du chanfrein.

7. Elément de détection selon l'une des revendications 5 ou 6, **caractérisé en ce que** la deuxième partie (516) du chanfrein s'étend dans la perforation (25) de mise en contact jusqu'à une profondeur non inférieure à 10 µm et en particulier non inférieure à 30 µm et/ou s'étend dans la perforation (25) de mise en contact jusqu'à une profondeur non inférieure à 2,5 % de l'épaisseur de la première couche (21) d'électrolyte solide et en particulier non inférieure à 7,5 % de l'épaisseur de la première couche (21) d'électrolyte solide et/ou dans lequel la deuxième partie (516) du chanfrein s'étend dans la perforation. (25) de mise en contact jusqu'à une profondeur non supérieure à 100 µm et en particulier non supérieure à 50 µm et/ou s'étend dans la perforation (25) de mise en contact jusqu'à une profondeur non supérieure à 20 % de l'épaisseur de la première couche (21) d'électrolyte solide et en particulier non supérieure à 10 % de l'épaisseur de la première couche (21) d'électrolyte solide.

8. Elément de détection selon l'une des revendications 5 à 7, **caractérisé en ce que** la première partie (515) du chanfrein et la deuxième partie (516) du chanfrein sont toutes deux rectilignes au moins par parties dans la direction radiale et se raccordent dans la direction radiale sous un angle (60) de parties de chanfrein et en particulier sous un angle (60) de parties de chanfrein non inférieur à 10° et non supérieur à 55° et en particulier sous un angle (60) entre parties du chanfrein non inférieur à 25° et non supérieur à 45°.

9. Elément de détection selon l'une des revendications 5 à 8, **caractérisé en ce que** la deuxième partie (516) du chanfrein forme avec le côté supérieur (211) de la couche (21) d'électrolyte solide et/ou avec le côté inférieur (212) de la première couche (21) d'électrolyte solide un angle (61) qui n'est pas inférieur à 3° et qui n'est pas supérieur à 25° et en particulier qui n'est pas inférieur à 6° et qui n'est pas supérieur à 16°.

10. Elément de détection selon l'une des revendications 5 à 9, **caractérisé en ce que** la deuxième partie (516) du chanfrein est rectiligne au moins par parties dans la direction radiale et **en ce que** la première partie (515) du chanfrein est arrondie au moins par parties dans la direction radiale, en particulier à un rayon de courbure de 10 µm à 200 µm et en particulier à un rayon de courbure de 25 µm à 115 µm, la deuxième partie (516) du chanfrein et la première partie (515) du chanfrein se raccordant l'une à l'autre dans la direction radiale en particulier sous un angle (60) entre parties de chanfrein inférieur à 5°, en particulier inférieur à 1° et en particulier en plan.

11. Elément de détection selon l'une des revendications 1 à 10, **caractérisé en ce que** la paroi (251) de la perforation (25) de mise en contact présente un chanfrein (51) à la fois sur le bord inférieur et sur le bord supérieur de la perforation (25) de mise en contact.

12. Elément de détection selon l'une des revendications 1 à 11, **caractérisé en ce que** l'élément isolant (42) est disposé en forme de couche sur la paroi (251) de la perforation (25) de mise en contact et présente sur au moins 90 % de la paroi (251) de la perforation (25) de mise en contact et en particulier sur au moins 97 % de la paroi (251) de la perforation (25) de mise en contact une épaisseur comprise entre une épaisseur minimale et une épaisseur maximale admissible, l'épaisseur minimale étant comprise dans la plage de 5 µm à 14 µm et valant par exemple 10 µm, l'épaisseur maximale admissible étant comprise dans la plage de 16 µm à 30 µm et étant par exemple de 20 µm.

13. Elément de détection selon l'une des revendications 1 à 12, **caractérisé en ce que** l'élément isolant (42) présente un ou deux des matériaux suivants :
Al₂O₃, en particulier α-Al₂O₃ et en particulier à une teneur supérieure à 50 % en poids,
une phase vitreuse et en particulier une phase vitreuse hautement isolante, par exemple un verre Celsian ou un verre au Ba-Si-La, en particulier à une teneur inférieure à 50 %.

14. Procédé de formation d'un élément de détection (20) selon l'une des revendications précédentes, le procédé étant **caractérisé en ce qu'**il prévoit les étapes suivantes, en particulier dans la succession indiquée :
formation d'une feuille crue (21') d'électrolyte solide, par exemple en ZrO₂ stabilisé par Y, Ca et/ou Sc,
formation d'une perforation (25) de mise en contact dans la feuille (21') d'électrolyte solide par estampage, gaufrage ou forage sur un ou deux côtés, en particulier au moyen d'un foret mécanique ou au moyen d'un rayonnement laser,
application simple ou multiple d'une pâte isolante (42') et/ou d'une suspension isolante dans la perforation (25) de mise en contact, par impression, sérigraphie, aspiration ou compression sur une face ou deux faces, projection et/ou égouttage, avec ensuite séchage et en particulier également séchages intermédiaires supplémentaires en cas d'application multiple,
application simple ou multiple d'une pâte conductrice (41') dans la perforation (25) de mise en contact en aspirant la pâte conductrice (41) par la perforation (25) de mise en contact et/ou en imprimant la pâte conductrice (41) sur la surface de la feuille (21') d'électrolyte solide,
frittage de l'élément de détection (20), entraînant le frittage conjoint de la pâte conductrice (41') et de la pâte isolante (42') et/ou de la suspension isolante et/ou le frittage conjoint de la feuille (21') d'électrolyte solide et de la pâte isolante (42') et/ou de la suspension isolante.

15. Procédé selon la revendication 14, **caractérisé en ce que** la formation de la perforation (25) de mise en contact s'effectue à l'aide d'un ou plusieurs outils (25') et en particulier d'un ou plusieurs forets mécaniques et/ou outils d'estampage, au moins une partie des outils (25') présentant une forme qui correspond essentiellement à la forme de la perforation (25) de mise en contact à former ou correspondant essentiellement à la forme d'au moins une partie de la perforation (25) de mise en contact à former.

16. Procédé selon les revendications 14 ou 15, dans lequel l'application d'une pâte isolante (42') et/ou d'une suspension isolante dans la perforation (25) de mise en contact s'effectue par aspiration sur les deux côtés et prévoit les étapes partielles suivantes, en particulier dans la succession indiquée :
- application de la pâte isolante (42') et/ou de la suspension isolante sur le côté supérieur (211) de la feuille (21') d'électrolyte solide au niveau de la perforation (25) de mise en contact,
- aspiration de la pâte isolante (42') et/ou de la suspension isolante à travers la perforation (25) de mise en contact en appliquant une dépression sur le côté inférieur (212) de la feuille (21') d'électrolyte solide au niveau de la perforation (25) de mise en contact,
- application de la pâte isolante (42') et/ou de la suspension isolante sur le côté inférieur (212) de la feuille (21') d'électrolyte solide au niveau de la perforation (25) de mise en contact et
- aspiration de la pâte isolante (42') et/ou de la suspension isolante à travers la perforation (25) de mise en contact en appliquant une dépression sur le côté inférieur (212) de la feuille (21') d'électrolyte solide au niveau de la perforation (25) de mise en contact.

17. Procédé selon la revendication 16, **caractérisé en ce que** la dépression, la consistance de la pâte isolante (42') et/ou de la suspension isolante ainsi que le nombre et la direction des aspirations et que la forme de la perforation (25) de mise en contact sont sélectionnés de telle sorte que sur la totalité de la paroi (251) de la perforation (25) de mise en contact se forme une couche de pâte isolante (42') et/ou de suspension isolante dont l'épaisseur est comprise entre 5 µm et 35 µm et en particulier entre 10 µm et 25 µm.

18. Procédé selon l'une des revendications 14 à 17, **caractérisé en ce que** la pâte isolante (42') et/ou la suspension isolante présentent des particules de matériau isolant et en particulier d'oxyde d'aluminium et présentent en outre des composants organiques, en particulier des plastifiants, des solvants et des liants, et **en ce que** la pâte isolante (41') présente des particules de métal précieux, en particulier de platine, et des particules d'électrolyte solide, en particulier d'YSZ, et présente en outre des composants organiques et en particulier des plastifiants, des solvants et des liants, au moins l'une des conditions suivantes étant satisfaite :
- la taille (d₉₀) des particules du matériau isolant, la taille (d₉₀) des particules de métal précieux et la taille (d₉₀) des particules d'électrolyte solide sont toutes comprises dans la plage de 0,8 µm à 2,5 µm,
- la taille (d₉₀) des particules du matériau isolant, la taille (d₉₀) des particules de métal précieux et la taille (d₉₀) des particules d'électrolyte solide ne s'écartent que de moins de 50 % de la plus grande des trois valeurs,
- la teneur en solides (% en poids) de la pâte isolante (42') et/ou de la suspension isolante ne se distingue de la teneur en solides (% en poids) de la pâte conductrice (42') que de moins de 20 % en poids,
- les teneurs (% en poids) en composants organiques de la pâte isolante (42') et/ou de la suspension isolante ne se distinguent de la teneur (% en poids) en composants organiques de la pâte conductrice (42') que de moins de 20 % en poids et
- la pâte isolante (42') et/ou la suspension isolante et la pâte conductrice (41') contiennent les mêmes composants organiques.

19. Procédé selon la revendication 18, dans lequel toutes lesdites conditions sont satisfaites.
